Europäisches Patentamt

European Patent Office

Office européen des brevets

(11) Publication number: **0 108 124**
**B1**

# EUROPEAN PATENT SPECIFICATION

(45) Date of publication of patent specification: 02.08.89

(51) Int. Cl.⁴: **H 03 K 7/06**

(21) Application number: 83901868.6

(22) Date of filing: 21.04.83

(86) International application number:
**PCT/US83/00615**

(87) International publication number:
**WO 83/04148 24.11.83 Gazette 83/27**

(54) Variable frequency generator responsive to digital data.

(30) Priority: 14.05.82 US 378037

(43) Date of publication of application:
16.05.84 Bulletin 84/20

(45) Publication of the grant of the patent:
02.08.89 Bulletin 89/31

(84) Designated Contracting States:
BE DE FR GB NL

(56) References cited:
US-A-4 206 424

No further documents cited

(73) Proprietor: MOTOROLA, INC.
1303 East Algonquin Road
Schaumburg Illinois 60196 (US)

(72) Inventor: CHAPMAN, Ronald H.
23 W. 583 Pine Drive
Wheaton, IL 60187 (US)

(74) Representative: Hudson, Peter David et al
Motorola Patent and Licensing Operations -
Europe Jays Close Viables Industrial Estate
Basingstoke Hampshire RG22 4PD (GB)

Courier Press, Leamington Spa, England.

## Description

This invention relates to variable frequency generators responsive to digital data.

Radio transceivers gain flexibility at reduced cost by the use of synthesizers as sources of the radio-frequency signals for transmission and for receiving. Such a circuit allows the use of a single frequency-determining element to enable a selection of many channels. This represents a significant saving over the use of multiple crystals, one for each channel that is to be used. When a synthesizer is used in the typical installation for land mobile or fixed station radio communication, using voice signals, a phase-locked loop may be used to generate a frequency that is deviated at an audio rate to produce a modulated signal. When the modulating signal is voice, there is no problem in controlling the deviation of the phase-locked loop and thus the synthesized frequency. When the modulating signal is voice which has a zero average value, the resultant deviation of the synthesizer output frequency around the carrier frequency is a very close representation of the modulating signal.

The situation changes, however, when it is desired to use frequency-shift keying to send digital data in a circuit that uses a synthesizer. There is a significant probability that the data will have a non-zero average value. In other words, the data may have a DC component. The operation of a synthesizer is such that it will not maintain the DC component of a signal, but will cause the average value (the DC component) of the signal to approach asymptotically the at-rest carrier frequency. The long-term effect of this action is to generate unequal frequency deviation of the signal around the carrier value.

From United States patent no. 4206424 there is known a circuit for generating a variable frequency signal which varies in response to the digital data consisting of a continuous train of equally significant bits.

However, this known circuit operates only on the instantaneous state of the digital data, that is it can operate only in a synchronous manner between the data and the added and subtracted pulses, which is required in order to maintain the precise phase angle control necessary when dealing with phase modulation.

It is an object of the invention to provide a circuit for generating a variable frequency signal which varies in response to digital data and which may be operated asynchronously.

In accordance with the present invention there is provided a circuit for generating a variable frequency signal which varies in response to digital data consisting of a continuous train of equally significant bits, said circuit comprising a source of pulses at a fixed frequency and providing means connected to receive said fixed frequency pulses from the source and to provide output pulses whose frequency is selectively altered in response to a predetermined number of bits of said digital data of the same polarity;

said providing means comprising means for adding additional pulses such that said frequency of output pulses is varied in a first predetermined direction in response to a predetermined number of bits of said digital data of a first polarity;

said providing means comprising means for subtracting pulses so that said frequency of output pulses is varied in a second predetermined direction opposite said first predetermined direction in response to a predetermined number of bits of said digital data of a second polarity;

characterised by:

said adding means comprising a first dividing means responsive to a predetermined number of first polarity bits in the digital data, said first dividing means controlling the rate at which additional pulses are added to said output pulses, and said subtracting means comprising a second dividing means responsive to a predetermined number of second polarity bits in the digital data, said second dividing means controlling the rate at which pulses are subtracted form said output pulses.

Application of a predetermined number of digital data signals of one sign causes the periodic subtraction of the pulse at the subtractor, thus reducing the average frequency at the output from the pulse subtractor. The signal at the output from the subtractor is applied to a pulse adder which adds a pulse to the subtracted pulse train in response to a predetermined number of data pulses of the opposite sign. The output pulse train is thus varied in frequency in response to variation in the digital data input. The order of addition and subtraction may be reversed, and one of the functions can be performed in the feedback loop of a frequency synthesizer.

Fig. 1 is a block diagram of a circuit for the practice of the invention.

Fig. 2 is a detailed circuit diagram of the circuit of Fig. 1.

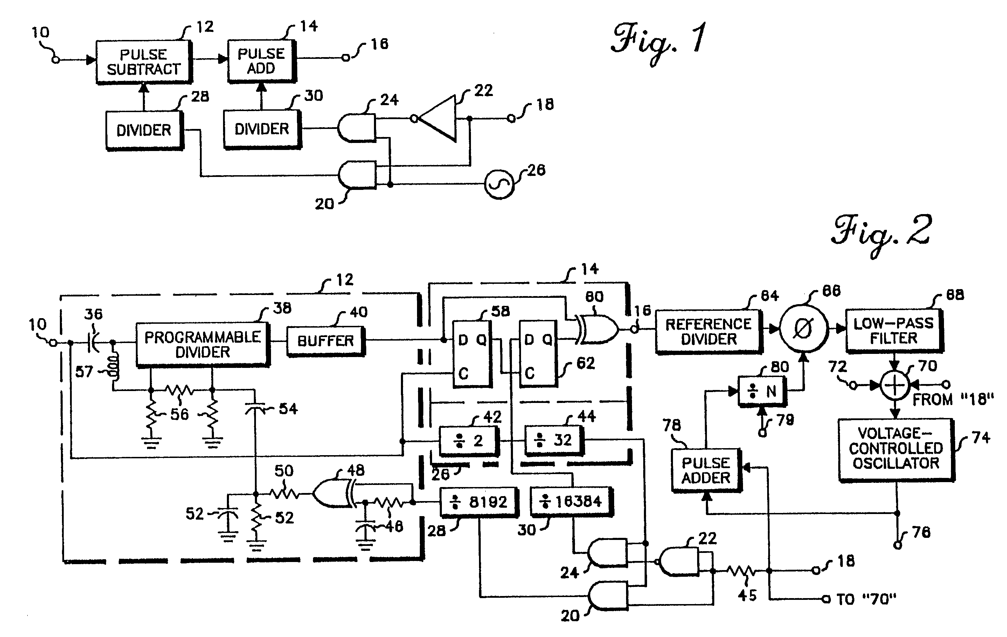

Fig. 1 is a block diagram of a circuit for the practice of the invention. In Fig. 1, a fixed reference AC voltage is applied at terminal 10 to a pulse subtractor 12. The frequency at terminal 10 is supplied by a precision frequency source such as a crystal oscillator. The output of subtractor 12 is connected to a pulse adder 14 which produces an output at terminal 16 at a frequency which is adjusted with respect to the input frequency at terminal 10. The adjustment is a function of digital data in binary form that is applied at terminal 18. The data from terminal 18 is applied as one input to AND gate 20 and also as an input to inverter 22. The output of inverter 22 is taken as one input to AND gate 24. A second input to AND gates 20 and 24 is supplied by oscillator 26. The output of AND gate 20 is divided by a constant K in divider 28, and the divided result is taken to control subtractor 12 to subtract pulses from the input at terminal 10. The output of AND gate 24 is taken to divider 30 where it is divided by a constant, here taken as the same K, and applied to control pulse adder 14 to add pulses to the input signal at terminal 10. The purpose of the circuit of Fig. 1 is to subtract a

predetermined number of pulses from the referenced signal at terminal 10 for each predetermined number of bits of one sign applied at terminal 18 and to add a number of pulses, here the same number, to the signal applied at reference 10 for each predetermined number of bits of the opposite sign applied at terminal 18.

The operation of the circuit of Fig. 1 can be understood by considering first the range of frequencies involved. The data applied at terminal 18 are typically binary signals at a base frequency of the order of hundreds of Hz. The signal applied at reference 10 is the fixed reference frequency for a synthesizer which is typically at a frequency of the order of MHz or tens of MHz. The frequency of oscillator 26 is selected in conjunction with the divider constant K of dividers 28 and 30 to add or subtract a predetermined number of pulses from the signal applied at terminal 10 for each binary digit or predetermined number of binary digits applied at terminal 18. Details of the selection will become apparent in a consideration of the actual circuits involved. However, it should be evident from an inspection of Fig. 1 that if it is desired to make one correction for each data bit applied at terminal 18, then the frequency of oscillator 26 should be chosen equal to the product of the data frequency at terminal 18 and the dividing constant K of dividers 28 and 30. If it is desired to make two corrections per data cycle, then the frequency of oscillator 26 should be twice the product of the frequency of data applied at terminal 18 and the constant K of dividers 28 and 30. In the application for which the circuit of the present invention was developed, it was desired to shift the output of the circuit for an amount that was proportional to the shift in the average value of the data input. It is equally possible to vary the shift in the two directions by making the dividing constants unequal. This is a matter of design choice.

Fig. 2 is a circuit diagram of a circuit for the practice of the present invention. In Fig. 2, elements that correspond to those of Fig. 1 are given corresponding numbers. Thus, in Fig. 2, terminal 10 receives a properly buffered signal at 14.4 MHz from a source such as a crystal-controlled oscillator. That signal is squared as necessary to form a pulse train and is applied to subtractor 12, which includes a blocking capacitor 36 that is coupled to a programmable divider 38. The programmable divider 38 is capable of dividing by either three or four under external control. When programmable divider 38 divides by three, it produces a signal at 4.8 MHz that will be seen to be the nominal output frequency at terminal 16. It is intended to take this signal as the reference frequency source for a synthesizer in an FM transceiver. If the frequency to be generated by the synthesizer is modulated with voice or data having no DC components, there would be no reason to cause any change in the frequency of the 4.8-MHz reference signal. However, if the presence of data with a non-zero average value makes it desirable to reduce the frequency applied to the synthesizer, then programmable divider 38 is caused from time to time to divide by four instead of three. This produces an output from programmable divider 38 that is a pulse train at a mixture of frequencies of 4.8 MHz and 3.6 MHz. The average value of this mixture will be some number less than 4.8 MHz, the amount depending upon the percentage of the time the programmable divider has been caused to divide by four instead of three. The output of programmable divider 38 is taken to buffer 40 from which it is applied to adder 14. It is evident that the result of causing programmable divider 38 to divide occasionally by four instead of three has had the effect of subtracting amounts from the frequency of the input signal at terminal 10, achieving the purpose of subtractor 12.

Control of subtractor 12 and of adder 14, to which it is connected, is accomplished in Fig. 2 by taking the signal at 14.4 MHz from terminal 10 to serve when modified as oscillator 26. Thus, the signal from terminal 10 is divided by two in divider 42 which is coupled to terminal 10, and the output of divider 42 is divided again by 32 in divider 44. This produces an output at 225 KHz which is the output of oscillator 26 of Fig. 1. This output is taken as an input to AND gates 20 and 24 of Fig. 2. Data bits applied at terminal 18 are taken through a resistor 45 as a second input to AND gate 20 and through inverter 22 as the second input to AND gate 24. Inverter 22 as shown here was actually a NAND gate with both inputs taken from terminal 18. With a bit rate of the order of 150 hertz applied at the terminal 18, it can be seen that a bit of one sign will enable AND gate 20, passing pulses at a frequency of 225 KHz to divider 28. This is set to divide by 8192. The result is to produce pulses at 27.47 Hz which are taken to subtractor 12. There they are applied both directly and through a low-pass filter 46 to an EXCLUSIVE-OR (E0) gate 48. The output of EO gate 48 is taken through resistor 50, filtered in low-pass filter 52, and taken through blocking capacitor 54. There it is applied both directly and through a resistive network 56 to programmable divider 38. An RF choke 57 completes the connection of external elements at programmable divider 38. The result is that whenever AND gate 20 is enabled, divider 28 begins to accumulate a count. Suppose first that it is a binary "1" that enables AND gate 20 and that a steady stream of 1's is applied at terminal 18. Divider 28 will produce pulses at 27.47 Hz which are shaped into narrow pulses of the same frequency by the combination of low-pass filter 46 and EO gate 48. Programmable divider 38 will thus be caused to change its dividing ratio at a rate of 27.47 Hz. This represents the maximum rate at which the circuit of Fig. 2 will cause programmable divider 38 to shift to divide by four and hence will cause the maximum possible amount of subtraction and the lowest average values of the output frequency. Suppose now that a single bit from the same bit stream is applied at terminal 18. This will gate 1500 pulses of the output of divider 44 into divider 28. Since the 1500 pulses are fewer in number than the 8192 divide ratio of divider 28, that count will be accumulated. Divider 28 will produce no output until it has had a total of approximately six such pulses (actually, 8192/1500 = 5.46). This accumulation of counts in divider 28 reduces the amount of switching of programmable divider 38.

If it becomes desirable to increase the frequency at terminal 16 above that of the output of subtractor 12, then adder 14 is caused to operate. Adder 14 comprises a D flip-flop 58 which is clocked by the signal at 14.4 MHz that was applied at terminal 10. The output of subtractor 12, which is an AC signal at an average frequency that is less than or equal to 4.8 MHz, is taken as the input to flip-flop 58 and also as one input to EO gate 60. The output of D flip-flop 58 is used to clock D flip-flop 62 which receives as an input the output signal from divider 30. Divider 30 divides by 16,384 to produce a signal that would be at 13.73 Hz if AND gate 24 were held on by a continuous signal to inverter 22. To follow the operation of adder 14, suppose that a signal containing all zeroes is supplied at terminal 18. This will cause inverter 22 to apply a signal at AND gate 24 while AND gate 20 is cut off. AND gate 24 will thus apply pulses at 225 KHz to divider 30, which produces output pulses at 13.73 Hz. This input to D flip-flop 62 will produce extra pulses at the output of D flip-flop 62 that cause EO gate 60 to produce extra pulses in the output from adder 14. The effect is to add pulses so that the output of EO gate 60 is at a higher frequency than the output of subtractor 12. For this reason, it is appropriate to refer to adder 14 as an adder.

The circuit of Fig. 2 has as its objective the generation of an AC signal at terminal 16 that is caused to vary in frequency about the center value of 4.8 MHz as a function of the average value of the data. The values chosen for the elements of Fig. 2 were selected to provide a particular desired amount of frequency variaton and response time. If it is desired to make the frequency change faster at terminal 16 in response to changes in the average value of data applied at terminal 18, this could be accomplished by reducing the divide ratios of any or all of dividers 42, 44, 28 and 30. For example, replacing divider 42 with a short circuit, removing a division by 2, would cause frequency changes to be made twice as often. The corner frequency of filter 46 determines the pulse width that EO 48 will generate. The width of this pulse is chosen to meet the input requirements of programmable divider 38. The circuit of Fig. 2 shows that, for equal excursions in the average value of the output, frequency dividers 30 and 28 were in a ratio of two to one. If it is desired to correct the frequency differently for bits of different sign, then the ratios of these two dividers with respect to one another could be changed correspondingly. It should also be evident that if the circuit of Fig. 2 is used in an FM transmitter that is used for both data and voice, it would be desirable to keep programmable divider set continually on divide by three and thus disable dividers 28 and 30 during voice transmission. Under this circumstance, adder 14 would not add, subtractor 12 would not subtract and the circuit would comprise blocking capacitor 36, programmable divider 38, set to divide by 3, buffer 40 and EO gate 60.

The circuit of Fig. 2 is most useful when it is applied as a source of a reference frequency for a synthesizer in a radio transmitter or receiver. The output of terminal 16 in Fig. 2 is taken to a reference divider 64 which divides the reference frequency at terminal 16 by an integer that is chosen to relate the output frequency of the reference divider 64 to the channel separation that is desired in the output frequency of the synthesizer. Typical band spacings for channels in various land-mobile bands are 20, 25, and 30Khz. An appropriately chosen one of these values would be selected for the output of reference divider 64 if the output of the synthesizer of Fig. 2 were used directly to set the frequency of transmission or of a local oscillator for a receiver. If the output of the synthesizer is to be multiplied by a constant to achieve the desired final frequency, then the desired band spacing must be divided by that same constant to achieve the desired output of reference divider 64. A later example will make this clear.

The output of reference divider 64 is taken to a phase detector 66 which produces an output that is taken to low-pass filter 68. The filtered output from low-pass filter 68 is taken to summer 70 where it is combined either with a data modulating signal from terminal 18 or with a voice modulating signal from terminal 72. The output of summer 70 controls voltage-controlled-oscillator (VCO) 74 which generates the desired output frequency at terminal 76. The output of VCO 74 is also taken through pulse adder 78 to divider 80 where it generates a feedback signal that is taken to phase detector 66 to close the loop of the synthesizer.

The circuit of Fig. 2 without pulse adder 78 has been built and used in a synthesized radio transmitter operating at a frequency of the·order of 900 MHz. This was accomplished by multiplying the output signal from VCO 74 by 6. The reference frequency supplied at terminal 10 was 14.4 MHz and the frequency of the data applied at terminal 18 was approximately 150Hz. The digital signal applied at terminal 18 was at a level of zero volts for a binary "0" and five volts for a binary "1". This will be referred to as the signal of the first polarity. Its inverse, zero volts for a binary "1" and five volts, for a binary "0" is the signal of the second polarity. These are matters of design choice. Appropriate frequencies in the circuit are summarized in the Table which lists the elements of Fig. 2 and the frequency of the output from each. Referring to the Table, it can been seen that the output of programmable divider 38 is 4.8 MHz for a divisor of 3 and 3.6 MHz for a divisor of 4. In the absence of a data input at terminal 18, programmable divider 38 will be set to divide by 3 and thus produce an output of 4.8 MHz. When a data bit at terminal 18 causes programmable divider 38 to change to a different divisor, the result is to produce a few bits at 3.6 MHZ, reducing the average value of the output to some figure less than 4.8 MHz. By this means, programmable divider 38 can be said to subtract from the nominal frequency of 4.8 MHz.

In the circuit for which values are represented in the Table, binary digits at a frequency of 150 Hz were applied to terminal 18. The output of divider 44 was applied as one input to AND gates 20 and 24.

TABLE

Frequencies of outputs of elements of Fig. 2

| OUTPUT OF | FREQUENCY |
|---|---|
| Terminal 10 | 14.4MHz |
| Programmable divider 38: | |
| ÷3 | 4.8MHz |
| ÷4 | 3.6MHz |
| Divider 42 | 7.2MHz |
| Divider 44 | 225KHz |
| Terminal 18 | 150Hz |
| AND gate 20 | 225KHz |
| (per data bit: 1500 pulses) | |
| AND gate 24 (per data bit: 1500 pulses) | 225KHz |
| Divider 28 (one pulse per 5.46 data bits) | 27.47Hz Max. |
| Divider 30 (one pulse per 10.92 data bits) | 13.73Hz Max. |
| Terminal 16 | 4.8MHz ± f |
| Reference divider 64 | 2083.$\bar{3}$Hz ± f' |
| Low-pass filter 68 | near DC |
| Summer 70 | Audio or data |
| VCO 74 | 150MHz nominal |
| Divider 80 | 2083.$\bar{3}$Hz ± f' |

As a result, when either and gate 20 or 24 was gated on by a data bit of an appropriate sign, its output was 1500 pulses per data bit of that sign. Thus, the output of divider 28 produces one corrective pulse per 5.46 data bits of the same sign and divider 30 produces one pulse per 10.92 data bit of the other sign. Terminal 16 produces a signal at a nominal 4.8 MHz, varied about that value by an amount designated f in response to the presence of data of one sign or the other. Reference divider 64 was here selected to produce a frequency that would control a synthesizer producing a frequency to be multiplied by 6 with band spacing of 25 Kilohertz. For this reason, the frequency output of reference divider 64 is 2083 1/3 Hz, one sixth of 25KHz, plus or minus a divided frequency variation f' that is introduced to correct for shifts of the average value of the data. Divider 80 is caused by the feedback action of the synthesizer to produce an output at the same frequency. The integral dividend of divider 80 is changed by one in response to a signal of terminal 79 to change channels in the transmitter that is controlled by the synthesizer of Fig. 2.

In the circuit that was built to practice the present invention, it was convenient to use the programmable divider 38 of Fig. 2 as the pulse subtractor 12 and the combination of flip-flop 58 and 62 and EO gate 60 of Fig. 2 as the pulse adder 14 of Fig. 1. This is a matter of circuit convenience since a 3/4 programmable divider is operable at relatively high frequencies and produces as an output a pulse train at a frequency that is lower than the input. It would be equally as effective, however, to reverse the order of pulse subtractor 12 and pulse adder 14 of Fig. 1 so that the input signal at terminal 10 was increased first in frequency and then decreased. This could be done quite readily by interchanging the elements of pulse subtractor 12 of Fig. 2 and those of pulse adder 14 of Fig. 2 so that terminal 10 was connected directly as an input to the D terminal of D flip-flop 58 and the output of EO gate 60 was taken as an input to programmable divider 38. Similarly, the pulse subtraction and pulse addition could have been carried out by cascading two programmable dividers. The first could be connected like programmable divider 38 of Fig. 2 so that the normal mode was a divide by 3 and the frequency adjustment was accomplished by dividing by 4. This results in a subtractor. If this were cascaded with a programmable divider that was set normally to divide by 4 but could be triggered as in Fig. 2 to divide by 3, then the programmable divider would comprise an adder. Such a cascade of dividers placed between terminals 10 and 16 of Figs. 1 or 2 would produce an output pulse train at a frequency 1/12 of the input frequency, adjustable up or down in response to shifts in the average value of the data input. The alternate modes described above are available for the choice of the designer.

**Claims**

1. A method for generating a variable frequency signal which varies in response to digital data consisting of a continuous train of equally significant bits, including the step of generating pulses at a fixed frequency and

providing output pulses based upon said fixed frequency pulses whose frequency varies in response to a predetermined number of bits of said digital data of the same polarity;

adding additional pulses to said output pulses such that the frequency of output pulses is varied in a first predetermined direction in response to a predetermined number of bits of said digital data of a first polarity;

subtracting pulses from said output pulses so that the frequency of output pulses is varied in a second predetermined direction opposite said first predetermined direction in response to a predetermined number of bits of said digital data of a second polarity;

charaterised by:

counting a predetermined number of first polarity bits of digital data, controlling the rate at which additional pulses are added to said output pulses in response to the predetermined number of first polarity bits, counting a predetermined number of second polarity bits of digital data, and controlling the rate at which pulses are subtracted from said output pulses in response to the predetermined number of second polarity bits.

2. A circuit for generating a variable frequency signal which varies in response to digital data consisting of a continuous train of equally significant bits, said circuit comprising a source (10) of pulses at a fixed frequency and providing means (12, 14, 20, 22, 24, 28, 30) connected to receive said fixed frequency pulses from the source (10) and to provide output pulses whose frequency is selectively altered in response to a predetermined number of bits of said digital data of the same polarity;

said providing means comprising means (14) for adding additional pulses such that said frequency of output pulses is varied in a first predetermined direction in response to a predetermined number of bits of said digital data of a first polarity;

said providing means comprising means (12) for subtracting pulses so that said frequency of output pulses is varied in a second predetermined direction opposite said first predetermined direction in response to a predetermined number of bits of said digital data of a second polarity;

characterised by:

said adding means comprising a first dividing means (30) responsive to a predetermined number of first polarity bits in the digital data, said first dividing means controlling the rate at which additional pulses are added to said output pulses, and said subtracting means comprising a second dividing means (28) responsive to a predetermined number of second polarity bits in the digital data, said second dividing means controlling the rate at which pulses are subtracted from said output pulses.

3. The circuit for generating a variable frequency signal of claim 2 characterised in that it is specially designed for use in a frequency synthesizer adapted to be modulated by a digital signal having a non-zero average value and consisting of a train of equally significant bits, said providing means including means (12, 14, 20, 22, 24, 28, 30) for varying the pulse rate of said output pulses in response to a predetermined number of bits of said digital signal of the same polarity such that said predetermined numbers of bits of said digital signal of opposite polarity equally modulate the frequency synthesizer.

4. The frequency synthesizer according to claim 3 wherein said varying means (12, 14, 20, 22, 24, 28, 30) varies the pulse rate such that a first polarity bit of the digital signal and a second polarity bit of the digital signal having a polarity opposite the first bit each cause the frequency of the synthesizer to change an equal amount.

**Patentansprüche**

1. Verfahren zum Erzeugen eines Signals variabler Frequenz, die sich in Abhängigkeit von Digitaldaten ändert, die aus einem zusammenhängenden Zug gleich signifikanter Bits bestehen, umfassend den Schritt des Erzeugens von Impulsen mit einer festen Frequenz und

auf der Grundlage der genannten Festfrequenzimpulse das Abgeben von Ausgangsimpulsen, deren Frequenz in Abhängigkeit von einer vorbestimmten Anzahl von Bits gleicher Polarität der genannten digitalen Daten schwankt;

Hinzufügen zusätzlicher Impulse zu den genannten Ausgangsimpulsen, so daß die Frequenz der Ausgangsimpulse in einer ersten vorbestimmten Richtung in Abhängigkeit von einer vorbestimmten Anzahl von Bits gleicher Polarität der genannten digitalen Daten verändert wird;

Subtrahieren von Impulsen von den genannten Ausgangsimpulsen, so daß die Frequenz der Ausgangsimpulse in einer zweiten vorbestimmten Richtung entgegengesetzt zu der ersten vorbestimmten Richtung in Abhängigkeit von einer vorbestimmten Anzahl Bits einer zweiten Polarität verändert wird;

gekennzeichnet durch:

das Zählen einer vorbestimmten Anzahl von Digitaldatenbits der ersten Polarität, Beeinflussen der Rate, mit der zusätzliche Impulse zu den Ausgangsimpulsen addiert werden, in Abhängigkeit von der vorbestimmten Anzahl Bits der ersten Polarität, Zählen einer vorbestimmten Anzahl von Digitaldatenbits der zweiten Polarität und Beeinflussen der Rate, mit der Impulse von den Ausgangsimpulsen subtrahiert werden, in Abhängigkeit von der vorbestimmten Anzahl Bits der zweiten Polarität.

2. Schaltung zur Erzeugung eines Signals variabler Frequenz, die sich in Abhängigkeit von Digitaldaten ändert, die aus einem zusammenhängenden Zug gleich signifikanter Bits bestehen, welche Schaltung enthält: eine Quelle (10) für Impulse einer festen Frequenz, und eine Abgabeeinrichtung (12, 14, 20, 22, 24, 28, 30), die so angeschlossen ist, daß sie die Festfrequenzimpulse von der Quelle (10) entgegennimmt und Ausgangsimpulse abgibt, deren Frequenz in Abhängigkeit von einer vorbestimmten Anzahl von Bits der genannten Digitaldaten der gleichen Polarität wahlweise geändert wird;

welche Abgabeeinrichtung eine Einrichtung (14) zum Addieren zusätzlicher Impulse enthält, so daß die Frequenz der Ausgangsimpulse in einer ersten vorbestimmten Richtung in Abhängigkeit von einer vorbestimmten Anzahl von Digitaldatenbits einer ersten Polarität geändert wird;

welche Abgabeeinrichtung eine Einrichtung (12) zum Subtrahieren von Impulsen enthält, so daß die Frequenz der Ausgangsimpulse in einer zweiten vorbestimmten Richtung entgegengesetzt zu der ersten vorbestimmten Richtung in Abhängigkeit von einer vorbestimmten Anzahl von Digitaldatenbits einer zweiten Polarität geändert wird;

dadurch gekennzeichnet, daß:

die Addiereinrichtung eine erste Teilereinrichtung (30) enthält, die auf eine vorbestimmte Anzahl von Bits der ersten Polarität in den digitalen Daten anspricht, welche erste Teilereinrichtung die Rate beeinflußt, mit der zusätzliche Impulse zu den Ausgangsimpulsen hinzugefügt werden, und daß die Subtrahiereinrichtung eine zweite Teilereinrichtung (28) enthält, die auf eine vorbestimmte Anzahl von Bits der zweiten Polarität in den digitalen Daten anspricht, welche zweite Teilereinrichtung die Rate beeinflußt, mit der Impulse von den genannten Ausgangsimpulsen abgezogen werden.

3. Schaltung zum Erzeugen eines Signals variabler Frequenz nach Anspruch 2, dadurch gekennzeichnet, daß sie speziell zur Verwendung in einem Frequenzsynthesizer gestaltet ist, der dazu eingerichtet ist, durch ein digitales Signal moduliert zu werden, das einen von Null abweichenden Mittelwert hat und aus einem Zug gleich signifikanter Bits besteht, und daß die Abgabeeinrichtung eine Einrichtung (12, 14, 20, 22, 24, 28, 30) enthält, um die Impulsrate der genannten Ausgangsimpulse in Abhängigkeit von einer vorbestimmten Anzahl Bits gleicher Polarität des genannten digitalen Signals zu variieren, so daß die vorbestimmten Anzahlen von Digitalsignalbits entgegengesetzter Polarität den Frequenzsynthesizer gleich modulieren.

4. Frequenzsynthesizer nach Anspruch 3, bei dem die Variiereinrichtung (12, 14, 20, 22, 24, 28, 30) die Impulsrate derart variiert, daß ein Digitalsignalbit der ersten Polarität und ein Digitalsignalbit der zweiten Polarität, die entgegengesetzt zu der des ersten Bits ist, jeweils bewirken, daß die Frequenz des Synthesizers sich um den gleichen Umfang ändert.

**Revendications**

1. Procédé de production d'un signal de fréquence variable qui varie en réponse à des données numériques consistant en un train continu de bits de même signification, consistant à produire des impulsions à une fréquence fixe et

à produire des impulsions de sortie sur la base desdites impulsions de fréquence fixe dont la fréquence varie en réponse à un nombre prédéterminé de bits des bits de données numériques de la même polarité;

à additionner des impulsions supplémentaires auxdites impulsions de sortie de manière que la fréquence des impulsions de sortie soit modifiée dans une première direction prédéterminée en réponse à un nombre prédéterminè de bits desdites données numériques d'une première polarité;

à soustraire des impulsions desdites impulsions de sortie de manière que la fréquence des impulsions de sortie soit modifiée dans une seconde direction prédéterminée opposée à ladite première direction prédéterminée en réponse à un nombre prédéterminé de bits desdites données numériques d'une seconde polarité;

caractérisé en ce qu'il consiste également:

à compter un nombre prédéterminé de bits de première polarité des données numériques, à commander la fréquence à laquelle des impulsions supplémentaires sont additionnées auxdites impulsions de sortie en réponse au nombre prédéterminé de bits de première polarité, à compter un nombre prédéterminé de bits de seconde polarité des données numériques et à commander la fréquence à laquelle des impulsions sont soustraites desdites impulsions de sortie en réponse au nombre prédéterminé des bits de seconde polarité.

2. Circuit de production d'un signal de fréquence variable qui varie en réponse à des données numériques consistant en un train continu de bits de mème signification, ledit circuit comportant une source (10) d'impulsions à une fréquence fixe et un dispositif de production (12, 14, 20, 22, 24, 28, 30) connecté pour recevoir lesdits impulsions de fréquence fixe provenant de la source (10) et produisant des impulsions de sortie dont la fréquence est modifiée sélectivement en réponse à un nombre prédéterminé de bits desdites données numériques de la méme polarité;

ledit dispositif de production comprenant un dispositif (14) destiné à additionner des impulsions supplémentaires de manière que ladite fréquence des impulsions de sortie soit modifiée dans une première direction prédéterminée en réponse à un nombre prédéterminé de bits desdites données numériques d'une méme polarité, ledit dispositif de production comprenant un dispositif (12) destiné à soustraire des impulsions de manière que ladite fréquence des impulsions de sortie soit modifiée dans une seconde direction prédéterminée opposée à ladite première direction prédéterminée en réponse à un nombre prédéterminé de bits desdites données numériques d'une seconde polarité;

caractérisé en ce que:

ledit dispositif d'addition comporte un premier dispositif de division (30) réagissant à un nombre prédéterminé de bits de première polarité dans les données numériques, ledit premier dispositif de division commandant la fréquence à laquelle des impulsions supplémentaires sont additionnées auxdites impulsions de sortie et ledit dispositif de soustraction comportant un second dispositif de division (28) réagissant à un nombre prédéterminé de bits de la seconde polarité dans les données numériques, ledit second dispositif de division commandant la fréquence à laquelle des impulsions sont soustraites desdites impulsions de sortie.

3. Circuit de production d'un signal à fréquence variable selon la revendication 2, caractérisé en ce qu'il est conçu spécialement pour être utilisé dans un synthétiseur de fréquence agencé pour être modulé par un signal numérique ayant une valeur moyenne non nulle est consistant en un train de bits de même signification, ledit dispositif de production comprenant un dispositif (12, 14, 20, 22, 24, 28, 30) pour modifier la fréquence desdites impulsions de sortie en réponse à un nombre prédéterminé de bits desdites données numériques de la même polarité de manière que lesdits nombres prédéterminés de bits dudit signal numérique de polarités opposées modulent également le synthétiseur de fréquence.

4. Synthétiseur de fréquence selon la revendication 3, dans lequel ledit dispositif de modification (12, 14, 20, 22, 24, 28, 30) modifie la fréquence des impulsions de manière qu'un bit d'une première polarité du signal numérique et un bit d'une seconde polarité du signal numérique ayant une polarité opposée à celle du premier bit entrainent chacun que la fréquence du synthétiseur change d'une valeur égale.

*Fig. 1*

*Fig. 2*

EP 0 108 124 B1